# DEMANDE DE BREVET EUROPEEN

(11) **EP 1 280 206 A1**
(43) Date de publication de la demande: **29.01.2003**
(21) Numéro de dépôt: 01401984.8
(22) Date de dépôt: 24.07.2001
(51) Int. Cl.: H01L 27/112, H01L 27/105

(54) **Mémoire ROM**

(71) Demandeur: CSEM Centre Suisse d'Electronique et de Microtechnique SA, 2007 Neuchâtel (CH)
(72) Inventeur: Piguet, Christian, 2000 Neuchatel (CH); Cserveny, Stefan, 1066 Epalinges (CH); Masgonty, Jean-Marc, 2074 Marin (CH)
(74) Mandataire: Caron, Gérard

(57) **Abrégé**

Mémoire ROM comprenant une matrice (M) de cellules auxquelles sont raccordées des lignes de bits (lₙ₋₁, lₙ, lₙ₊₁) divisées chacune en une pluralité de tronçons (t1, t2, t3) à chacun desquels est connecté un groupe composé de cellules qui en fonction des valeurs binaires à stocker sont programmées à des valeurs binaires pouvant être de niveaux logiques opposés, les tronçons (t1, t2, t3) d'une même ligne de bits (lₙ₋₁, lₙ, lₙ₊₁) étant connectés respectivement à une logique de transfert (pₙ₋₁, pₙ, pₙ₊₁), à la sortie de laquelle apparaissent les valeurs binaires des cellules adressées.

Selon l'invention, les logiques de transfert (pₙ₋₁, pₙ, pₙ₊₁) sont disposées à l'extérieur contre un bord (B) de la matrice (M) sur lequel aboutissent les lignes de bits (lₙ₋₁, lₙ, lₙ₊₁) et chaque tronçon (t2, t3) non immédiatement adjacent à ce bord (B) est connecté à une entrée de la logique de transfert (pₙ₋₁, pₙ, pₙ₊₁) par une piste de métallisation (m2, m3) s'étendant parallèlement aux lignes de bits (lₙ₋₁, lₙ, lₙ₊₁).

## Description

La présente invention est relative à une mémoire ROM comprenant des lignes de bits divisées en une pluralité de tronçons.

Par US 5 836 007, on connaît une mémoire telle que définie dans le préambule de la revendication 1.

On sait que la division des lignes de bits en tronçons permet de réduire la capacité de sortie de chaque colonne d'une mémoire ROM, d'où résultent des avantages notamment sur le plan de la rapidité d'accès.

Dans le brevet antérieur précité, les logiques de transfert sont prévues dans la matrice elle-même et leurs connexions, notamment celles assurant leur alimentation et la transmission des valeurs de sortie vers d'autres circuits de la puce semi-conductrice, doivent donc y être menées en passant dans la matrice de cellules. Un tel agencement présente l'inconvénient de réduire la densité d'implantation des cellules de la mémoire et, par voie de conséquence d'augmenter la surface nécessaire sur la puce semi-conductrice.

L'invention a pour but de remédier à cet inconvénient.

Elle a donc pour objet une mémoire telle que définie en préambule et qui présente les particularités de la partie caractérisante de la revendication 1.

Grâce à ces particularités, la matrice de la mémoire ne comporte que les cellules et leurs lignes de connexion associées. La densité d'implantation des cellules s'en trouve améliorée, toutes les connexions nécessaires au fonctionnement des logiques de transfert étant reportées en dehors de la matrice, à l'exception des connexions reliant les tronçons des lignes de bits aux entrées de ces logiques de transfert.

D'autres particularités avantageuses de l'invention sont définies dans les sous-revendications.

Dans ce qui suit, l'invention va être présentée à l'aide de la description qui va suivre, donnée uniquement à titre d'exemple et faite en se référant aux dessins annexés sur lesquels:
- la figure 1 est une représentation topologique partielle d'une matrice de cellules pour mémoire ROM selon l'invention;
- la figure 2 est une représentation analogue illustrant une variante de la topologie de la figure 1; et
- la figure 3 est un schéma équivalent simplifié d'une colonne de cellules d'une mémoire ROM illustrant une caractéristique avantageuse de l'invention.

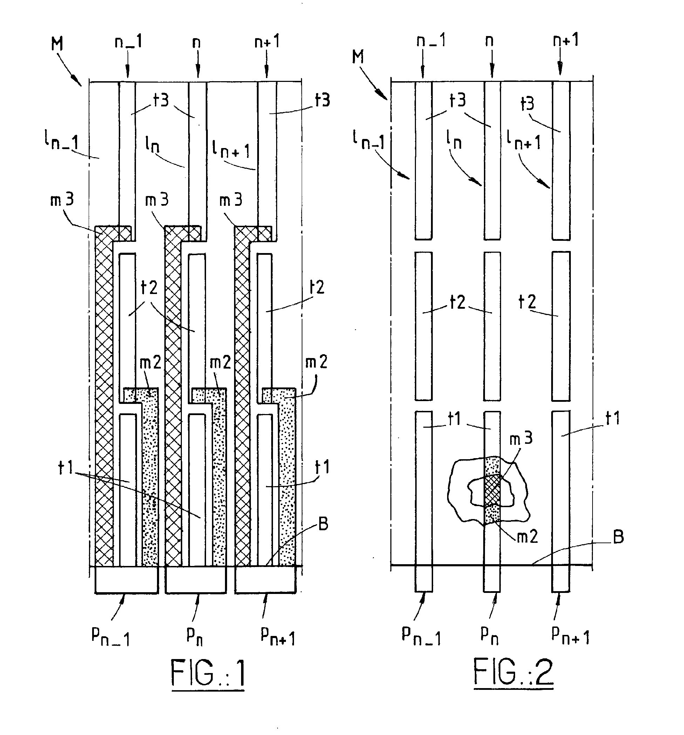

Sur la figure 1, on a représenté une matrice de cellules M dont on ne voit représentés ici que trois colonnes n-1, n et n+1. Cependant, comme cela est bien connu dans la technique, cette matrice de cellules est agencée pour former une mémoire ROM comprenant un très grand nombre de cellules accessibles par adressage matriciel d'un grand nombre de colonnes et de rangées.

Comme cela est également connu, les colonnes de la matrice M comportent des lignes de bits Iₙ₋₁, Iₙ, Iₙ₊₁ divisées en tronçons qui, dans l'exemple représenté, sont au nombre de trois, valeur qui n'est évidemment pas limitative. Les tronçons sont repérés par t1, t2 et t3.

Chaque tronçon t1, t2 et t3 est connecté à une logique de transfert pₙ₋₁, pₙ, pₙ₊₁ qui est agencée en dehors de la zone du substrat de la puce semi-conductrice dans laquelle est disposée la matrice M. Plus précisément, ces logiques de transfert sont disposées le long d'un des bords B de la matrice M sur lequel aboutissent les lignes de bits Iₙ₋₁, Iₙ, Iₙ₊₁. De façon particulièrement avantageuse, les logiques de transfert pₙ₋₁, pₙ, pₙ₊₁ sont implémentées sur la puce de façon à ce que leur largeur n'excède pas celle de la ligne de bit à laquelle chacune est connectée (voir la variante de la figure 2).

Pour ce qui concerne les tronçons t2 et t3 non immédiatement adjacents au bord B de la matrice M, il est prévu des métallisations de connexion m2 et m3 respectivement, formées par des pistes étroites s'étendant parallèlement à la direction générale des lignes de bits Iₙ₋₁, Iₙ, Iₙ₊₁. Chacune des ces métallisations est reliée à une entrée spécifique de la logique de transfert pₙ₋₁, pₙ ou pₙ₊₁.

Les tronçons t1 proches de ces logiques de transfert sont respectivement connectés directement à une autre entrée de celles-ci.

Du fait que les logiques de transfert sont disposées à la périphérie de la matrice M en dehors de la surface qu'elle occupe sur la puce semi-conductrice, la connexion des ces logiques exigées pour leur fonctionnement (alimentation, lignes de sortie etc.) peuvent bénéficier d'une topologie occupant nettement moins de place que si elles étaient prévues à l'intérieur de la surface occupée par la matrice M. Par conséquent, la densité globale d'implantation de la puce est plus favorable que dans les dispositions proposées par l'art antérieur.

Dans le mode de réalisation de la figure 1, les métallisations m2 et m3 peuvent être prévues à un même niveau dans le substrat que les tronçons. Cependant, selon une variante avantageuse de l'invention, on peut également prévoir des métallisations de connexion m2 et m3 à des niveaux différents dans le substrat, ce qui peut permettre de les superposer au moins partiellement aux lignes de bit dans les tronçons. Cette variante est représentée dans la vue avec arrachement partiel de la figure 2. Il en résulte une réduction supplémentaire de la surface occupée.

Il convient de noter que l'utilisation de connexions métalliques à des niveaux différents permet de réduire considérablement leur encombrement sur la puce par rapport à une configuration ne comportant qu'un seul niveau de métallisation.

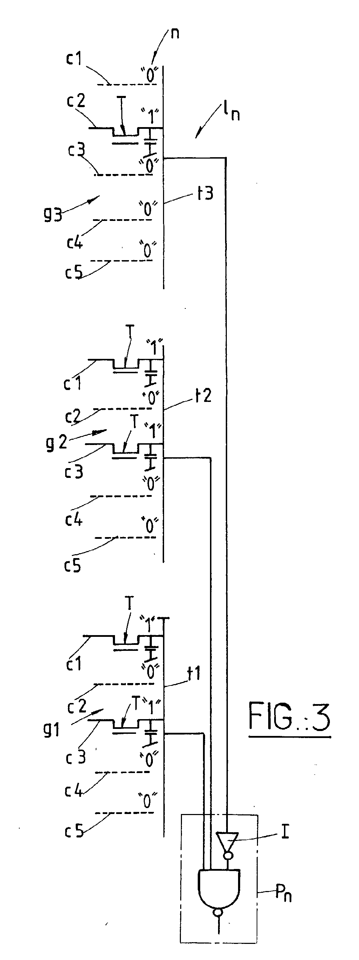

La figure 3 montre un schéma équivalent simplifié de la colonne n de la matrice M représentée sur les figures 1 ou 2.

Dans cet exemple, la ligne de bits Iₙ est également divisée en trois tronçons t1, t2 et t3 formant des groupes g1, g2 et g3 de cellules c1 à c5 qui sont ici supposées au nombre de cinq. Bien entendu, toutes ces valeurs ne sont données qu'à titre d'exemple.

Dans le type de mémoire ROM concerné par l'invention, le niveau binaire d'une cellule est programmé, par construction, par la présence ou l'absence d'un composant semi-conducteur intégré tel qu'un transistor, ce dernier pouvant, en étant rendu conducteur par l'adressage, déterminer l'un des niveaux binaires possibles du tronçon de la ligne de bits. Par ailleurs, le niveau logique opposé est déterminé par l'absence dans la cellule correspondante d'un tel composant semi-conducteur. Si une telle cellule est adressée, elle impose alors sur le tronçon de la ligne de bits le niveau logique opposé.

On comprend que la connexion d'un composant semi-conducteur d'une cellule, et en particulier celle d'un transistor, augmente la capacité du tronçon de ligne de bit associé, cette capacité étant d'autant plus élevée que dans un groupe de cellules, on doit stocker des bits ayant le niveau logique correspondant à la présence d'un composant. Il y aurait donc avantage à réduire autant que possible la présence des composants semi-conducteurs pour faire en sorte que la rapidité de lecture et la consommation ne soient pas pénalisées.

Cependant, la nécessité de prévoir un composant semi-conducteur dans une cellule est conditionnée par la valeur binaire du bit qui doit y être mémorisé de sorte qu'en définitive la topologie de la matrice est déterminée par le contenu de la mémoire et par le choix des niveaux logiques que l'on affecte aux tensions dans la matrice déterminant la présence ou l'absence d'un bit dans une cellule donnée.

Selon une caractéristique complémentaire avantageuse de l'invention visant à réduire les capacités affectant les tronçons, dans chaque groupe g1, g2, g3 (figure 3) des cellules c1 à c5 associées à un tronçon t1, t2, t3 d'une ligne de bits Iₙ₋₁, Iₙ, Iₙ₊₁, si une majorité de cellules nécessitent un transistor T selon la logique d'adressage dite "normale", alors les cellules sont programmées de manière opposée et leur sortie est complémentée au niveau de la logique de transfert.

Ainsi dans l'exemple de la figure 3, le groupe g3 comporte des cellules c1, c3, c4 et c5 dépourvues de transistor, tandis que la cellule c2 comporte un transistor T. Par contre, dans les groupes g1 et g2, on trouve des transistors T dans les cellules c1 et c3, les autres cellules de ces groupes étant dépourvues de transistor. Il est à noter que l'identité des groupes g1 et g2 est fortuite.

Ainsi, les valeurs binaires représentées par les cellules sont "0-1-0-0-0" et "1-0-1-0-0", respectivement dans le tronçon t3 et dans les tronçons 1 et 2.

On voit également que chaque tronçon t1, t2 et t3 de la ligne de bits Iₙ est raccordé à une logique de transfert pₙ qui dans l'exemple comporte une porte "NAND" et, éventuellement un inverseur I. On notera que le tronçon t3 est connecté à cette porte NAND par l'intermédiaire d'un inverseur I de sorte qu'à l'entrée correspondant de cette porte, les valeurs binaires représentées par les différentes cellules sont complémentées. Par conséquent, malgré le fait que le groupe g3 représente, du fait de sa topologie, quatre "0" et un "1" et ne comporte donc qu'un seul transistor, il fait apparaître à l'entrée de la porte NAND, en fonction de l'adressage sélectivement quatre "1" et un "O". Dans l'exemple représenté, on peut donc économiser trois transistors, l'économie étant, bien entendu, d'autant plus grande que le nombre de cellules par groupe est important.

On notera que les valeurs apparaissant aux sorties des logiques de transfert de la matrice peuvent être inverses de celles produites dans le cas du schéma de la figure 3.

## Revendications

1. Mémoire ROM comprenant une matrice (M) de cellules (c1 à c5) auxquelles sont raccordées des lignes de bits (Iₙ₋₁, Iₙ, Iₙ₊₁) divisées chacune en une pluralité de tronçons (t1, t2, t3) à chacun desquels est connecté un groupe (g1, g2, g3) composé de cellules (c1 à c5) qui, en fonction des valeurs binaires à stocker, sont programmées à des valeurs binaires pouvant être de niveaux logiques opposés, les tronçons (t1, t2, t3) d'une même ligne de bits (Iₙ₋₁, Iₙ, Iₙ₊₁) étant connectés respectivement à une logique de transfert (pₙ₋₁, pₙ, pₙ₊₁), à la sortie de laquelle apparaissent les valeurs binaires des cellules adressées (c1 à c5),
**caractérisée en ce que**
lesdites logiques de transfert (pₙ₋₁, pₙ, pₙ₊₁) sont disposées à l'extérieur contre l'un (B) des bords de ladite matrice (M) sur lequel aboutissent lesdites lignes de bits (Iₙ₋₁, Iₙ, Iₙ₊₁) et **en ce que** chaque tronçon (t2, t3) non immédiatement adjacent à ce bord (B) est connecté à une entrée de ladite logique (pₙ₋₁, pₙ, Pₙ₊₁) par une piste de métallisation (m2, m3) s'étendant parallèlement aux lignes de bits (Iₙ₋₁, Iₙ, Iₙ₊₁).

2. Mémoire selon la revendication 1, **caractérisée en ce que** lesdites pistes de métallisation (m2, m3) sont disposées à côté des lignes de bits (Iₙ₋₁, Iₙ, Iₙ₊₁).

3. Mémoire selon la revendication 1, **caractérisée en ce que** lesdites pistes de métallisation (m2, m3) sont prévues en superposition au moins partielle par rapport auxdites lignes de bits (Iₙ₋₁, Iₙ, Iₙ₊₁) à des niveaux de métallisation différents.

4. Mémoire selon l'une quelconque des revendications 1 à 3, **caractérisée en ce que** chacune des cellules (c1 à c5) de chaque tronçon (t1, t2, t3) comporte ou non un transistor (T) selon que la valeur à stocker est à une première ou une deuxième valeur logique et **en ce que** les tronçons (t1, t2, t3) sont prévus pour stocker la valeur vraie ou la valeur complémentée de telle sorte que le nombre requis de transistors soit minimum.

5. Mémoire selon la revendication 4, **caractérisée en ce que** ladite logique de transfert (pₙ₋₁, pₙ, pₙ₊₁) comprend une porte NAND et un inverseur (I).

6. Mémoire selon l'une quelconque des revendications 1 à 5, **caractérisée en ce que** lesdites logiques de transfert (pₙ₋₁, pₙ, pₙ₊₁) sont implémentées de telle façon que leur largeur n'excède pas celle de la ligne de bits à laquelle elles sont respectivement connectées.
